# EUROPEAN PATENT APPLICATION

(11) **EP 1 827 061 A2**
(43) Date of publication of application: **29.08.2007**
(21) Application number: 07250735.3
(22) Date of filing: 21.02.2007
(51) Int. Cl.: H05K 1/02, H05K 3/34

(54) **Facility and method for high-performance circuit board connection**

(30) Priority: 22.02.2006 US 360306
(71) Applicant: TEKTRONIX, INC., Beaverton, OR 97077 (US)
(72) Inventor: Ebbutt, Ralph, Oregon 97007 (US)
(74) Representative: Burke, Steven David

(57) **Abstract**

A circuit assembly has two circuit boards parallel to each other and having major faces facing each other. Each major face has a signal contact connected to a signal trace. At least one of the major faces has a ground contact surrounding the signal contact. The signal and ground contacts are connected by way of a column element defining an axis perpendicular to the board faces. The column element has an inner conductor electrically connecting the signal contact, and a shield electrically isolated from and surrounding the inner conductor. A number of the column elements, as well as solder elements, may be supported by a carrier, which is placed between the boards for an electrical connection process, and which then may be dissolved.

## Description

### Field of the Invention

The subject invention generally relates to the field of electronic interconnects, and more particularly to high performance connections between circuit boards.

### Background of the Invention

Electronic instruments and other devices are often assemblies of electronic systems and subsystems. For manufacturing efficiency, different systems are carried on different substrates, which may then be attached to a larger substrate or "mother board." These connections have several limitations.

One limitation of board-to-board connections is that conventional connections are made at the edge of one board, which has conductive strips that are received in a connector on the mother board. Thus, when a greater number of connections are needed, the edge dimensions may limit the number below a needed threshold. In addition, conventional edge connectors require a perpendicular arrangement between the mother board and the attached board, increasing the volume needed to contain the assembly.

Ball grid arrays have been employed to provide a connection between a board parallel to and overlaying a larger board. While effective for some applications, they suffer from performance deficiencies. A solder ball connection is capacitive, and can create excessive electrical parasitics that impair high-speed applications. In addition, this type of connection is susceptible to generating and receiving electrical crosstalk from other connections, because conventional solder ball connections lack the shielding that is found in other parts of the signal path, including on the boards, in cabling, and in other connections within and outside of the instrument.

Accordingly, there is a need for a method and apparatus for providing a compact, high performance connection between circuit boards. The preferred embodiment provides this in the following:

### Summary of the Invention

A circuit assembly has two circuit boards parallel to each other and having major faces facing each other. Each major face has a signal contact connected to a signal trace. At least one of the major faces has a ground contact surrounding the signal contact. The signal and ground contacts are connected by way of a column element defining an axis perpendicular to the board faces. The column element has an inner conductor electrically connecting the signal contact, and a shield electrically isolated from and surrounding the inner conductor. A number of the column elements, as well as solder elements, may be supported by a carrier, which is placed between the boards for an electrical connection process, and which then may be dissolved.

### Brief Description of the Drawings

Figure 1 is a perspective view of a preferred embodiment of the invention.

Figure 2 is an enlarged fragmentary view of the embodiment of Figure 1.

Figure 3 is an enlarged sectional side view of the embodiment of Figure 1.

Figure 4 is a perspective view of an alternative embodiment of the invention.

### Detailed Description of a Preferred Embodiment

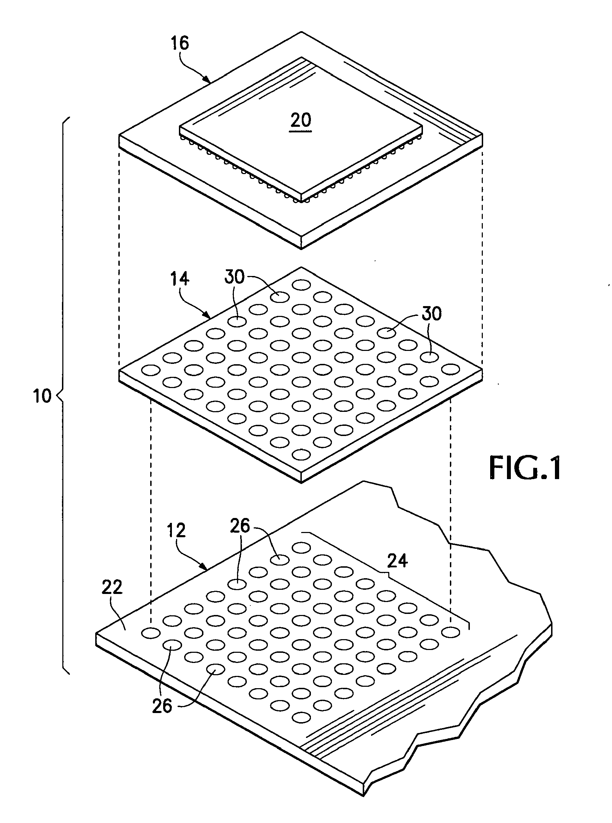

Figure 1 shows a circuit assembly 10 including a main circuit board 12, a connector matrix element 14, and a secondary circuit board 16 carrying an integrated circuit chip 20. The illustration is simplified from a typical assembly, in that only one secondary board, and only one chip are illustrated. In typical applications, the main board will support several secondary boards, each of which may be a subassembly carrying several chips and other circuit elements. The boards may be any substrate or carrier element, and need not be limited to traditional printed circuit board materials. The secondary board may itself be an integrated circuit or chip carrier, with similar means to be connected to the main board as will be discussed below.

The main board 12 has a major upper face 22 that has a grid array 24 of conductive pad patterns 26, each of which is connected to other circuitry on the board by traces (not shown) that extend on the surface of the board, or in layers within the board. The main board may be a mother board of a computer, or a board for a system or subsystem of any electronic instrument.

Above the board 12, the connector matrix element 14 is a solid body that contains a grid of conductive elements 30, with the grid arrayed the same as the array 24 of the board 12, so that each conductive element is registered with a pad 26.

The secondary board 16 has the chip mounted on the upper surface, and has a pattern of contacts on its lower surface in the same spacing and configuration as those of the matrix element 14 and main board array 24.

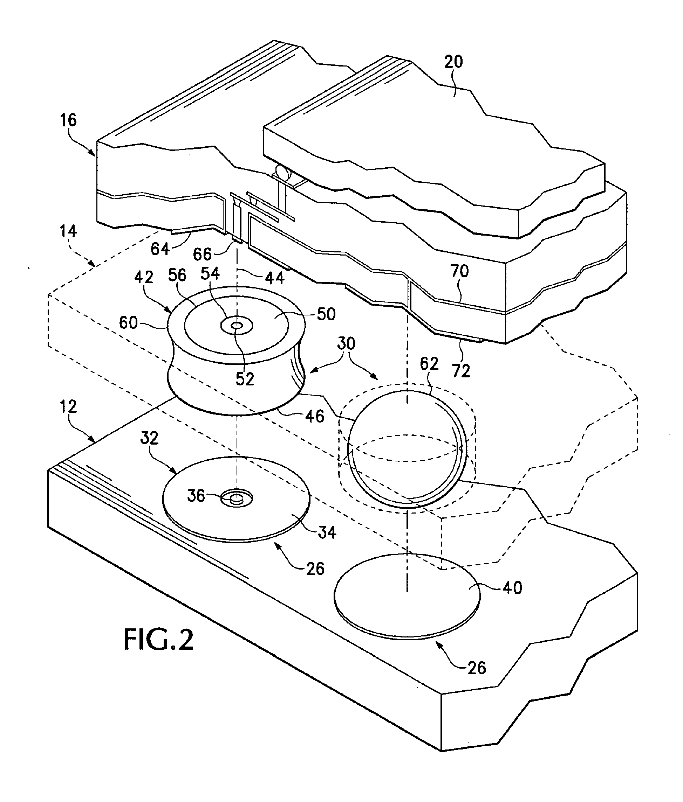

Figure 2 shows the connection facility in greater detail. The contacts 26 of the main board 12 are of one of two different types. A concentric contact type 32 is illustrated at left, with a large annular shield contact 34 surrounding and spaced apart from a central signal contact 36. Each of the contacts is connected by surface or internal connections to other circuitry. A simple contact pad 40 is shown at right, and is employed where high-speed signals are not transmitted, such as for power and ground connections.

The conductive elements 30 are of two different types. For the concentric contact 32, a concentric column element 42 is employed. The column is a cylinder defining an axis 44 that is perpendicular to the surfaces of the circuit boards. The column has a lower end face 46 and upper end face 50 that are perpendicular to the axis. The column has a central conductive signal conductor 52, a surrounding dielectric layer 54, which is surrounded by a conductive shield sleeve 56. The shield is coated by a layer of solder 60, which is in place for subsequent processing to provide connections. In the preferred embodiment, the signal conductor is a copper wire with a diameter of 0.20 to 0.25 mm, the dielectric can be teflon, glass, ceramic, or adhesive with a thickness of 0.15 to 0.20 mm, and the shield is formed of Ni-Au plated Cu, with an outer diameter of 0.6 to 0.75 mm. The solder layer has a thickness of 0.10 to 0.25 mm, giving the column a diameter of 0.70 to 1.00 mm. The column has a length of 0.50 to 3.00 mm.

The second type of conductive element that may occupy one of the cylindrical holes of the matrix 14 is a solder ball 62 that has a diameter to be closely received in the matrix holes. In the preferred embodiment, the matrix is formed of heat resistant, solder phobic material, has a thickness of 0.4 to 2.5 mm, holes on a 0.80 to 1.50 mm center-to-center spacing, and with a diameter of 0.75 to 1.05 mm. The hole diameter and matrix spacing are about the same, so that during heating, the solder will wick to contact both boards above and below. In an alternative embodiment, the matrix may be formed of a water-soluble flux resin carrier material such as poly-oxide resin and dissolvable paper, so that it may be washed away following the soldering process. The matrix may be assembled by either (i) inserting the elements into the an alignment plate/reflow carrier with a grid of holes (with larger diameter than the coaxial columns to enable self-alignment due to solder wetting forces during reflow) corresponding to the pad patterns on the boards , or (ii) a dissolvable matrix may be cast or molded about the array of conductive elements. In the first approach the substrate would be placed, aligned, and reflowed to the grid of elements. The elements would be co-planar in the carrier and protrude above the carrier to ensure solder wetting and attachment.

The upper board 16 has contacts on the lower face that are essentially the same as those shown on the upper surface of the main board. For connecting to a column element, an annular contact 64 connects to the shield 56, and a central signal contact 66 connects to the signal conductor 52. The upper surface of board 16 defines contacts that enable the connection of the chip, via solder bumps or any other means. The board has several internal layers, such as a ground plane 70 that connects to the pad 64, and which has openings where signal paths must pass through. A simple pad 72 on the lower surface provides a contact to the solder ball, and is connected to the ground plane.

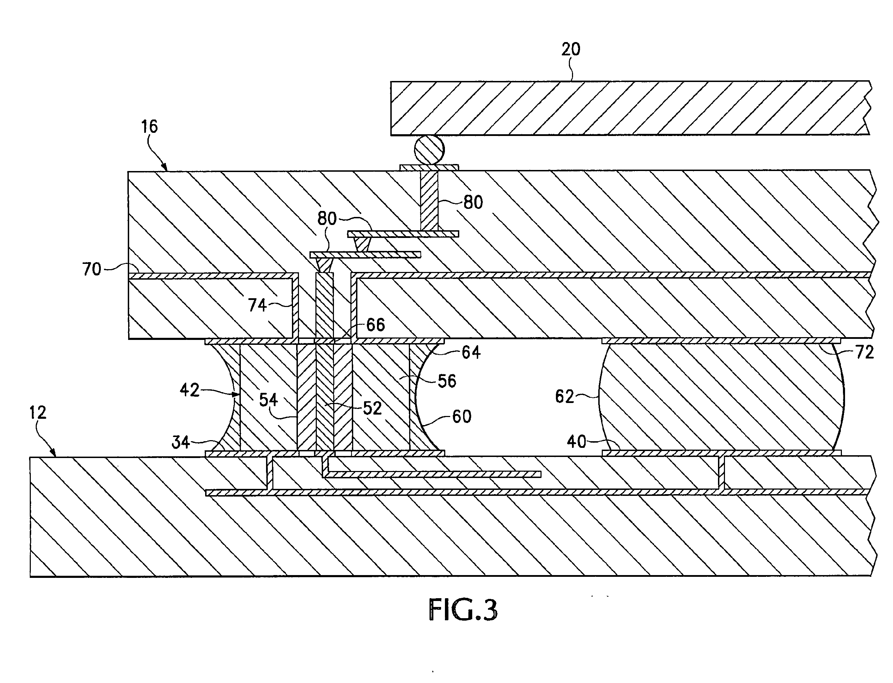

Figure 3 shows the two types of board-to-board connections following processing. After the matrix is filled, it and the boards are positioned with respect to each other, then heated above the solder melting temperature in a re-flow process. To secure the alignment, epoxy (conductive or not) may be employed to adhere the parts together before the reflow process. In the illustrated embodiment, the matrix has been dissolved, and the solder provides the mechanical connection in addition to an electrical connection. The solder layer 60 about column 42 has wicked to provide fillets at the ground pads 34, 64 on each board, and the solder ball 62 has similarly flowed to a stable position.

The internal layers and conductors of the boards are shown in greater detail in Figure 3. A ground sleeve 74 is a cylindrical tube extending from ground pad 64 to the ground plane 70, providing shielding about a signal via 76 that extends from pad 66 to internal conductive paths 80 that lead to the chip 20. The signal paths in each board are shown as simplified examples. In the preferred embodiment, they may employ any conventional configuration to provide the proper shielding and impedance, including with shield paths adjacent to a signal path on a common layer, and shield paths on layers above and below a signal trace.

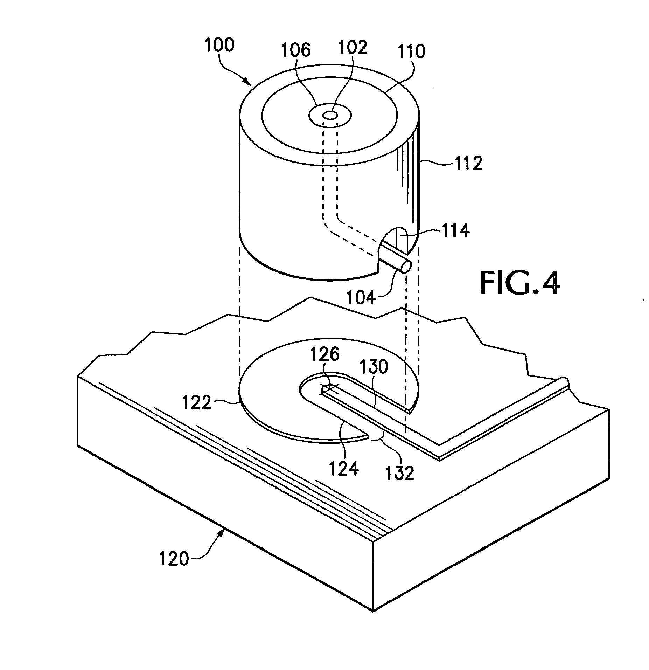

Figure 4 shows an alternative column element 100 that is employed on a substrate 102 with a different contact configuration. The column has a central signal core 102 that is flush with an upper surface of the column for connection to an upper board as discussed above. The core extends to a lower face of the column, and bends at a right angle to proceed laterally to an end portion 104 that extends beyond the dielectric 106, shield 110, and solder layer 112. The dielectric, shield and solder are cut with a relief channel 114 that extends radially from the center of the column at the bottom surface, to the periphery, so that there is a clearance gap between the core and the other layers. In the preferred embodiment, the core is bent, then inserted into the dielectric with a press fit, which is similarly received in the solder-coated shield layer.

The board 120 is similar to that in the preferred embodiment, with a grid array of contacts for columns of solder ball connections. However, the pattern for a column connection is as shown, with a circular ground pad 122 defining a radial gap 124 extending from a center point 126 of the circular periphery. A signal trace 130 extends from the center, with a gap 132 on all sides between the ground pad and the signal trace.

## Claims

1. A circuit assembly comprising:
a first circuit element having a first major face having a first signal contact connected to a signal trace;
a second circuit element having a second major face parallel to and opposing the first major face;
the second major face defining a second signal contact registered with the first signal contact;
a column element between the first signal contact and the second signal contact;
the column element defining an axis perpendicular to first and second major faces;
the column element having an inner conductor electrically connected to the first signal contact and to the second signal contact; and
the column element having a shield electrically isolated from and surrounding the inner conductor.

2. The circuit assembly of claim 1 wherein the shield is a cylindrical tube.

3. The circuit assembly of claim 1 wherein at least one of the first and second faces includes a ground contact connected to the shield.

4. The circuit assembly of claim 1 wherein the shield is connected to both ground contacts.

5. The circuit assembly of claim 1 wherein the ground contact surrounds at least one of the first and second signal contacts.

6. The circuit assembly of claim 1 wherein each ground contact surrounds each respective signal contact.

7. The circuit assembly of claim 1 including a plurality of column elements providing a plurality of signal paths.

8. The circuit assembly of claim 1 wherein each column element has parallel end faces perpendicular to the axis, the central inner conductor centered on the axis and surrounded by a dielectric sleeve, and dielectric sleeve surrounded by the shield.

9. The circuit assembly of claim 1 wherein the central inner conductor has a first portion extending between the ends of the column along the axis, and a second portion extending laterally at one end of the column.

10. A method of manufacturing an electronic assembly comprising the steps of:
providing a first circuit board having a plurality of first signal contacts on a first face;
providing a second circuit board having a plurality of second signal contacts corresponding to the first signal contacts on a second face;
positioning the first and second circuit boards parallel to each other with the first face facing the second face;
positioning a plurality of conductive column elements, each between a corresponding pair of first and second signal contact; and
electrically connecting the column elements to the first and second signal contacts;
wherein each of the circuit boards has a ground contact adjacent to the signal contact, the column elements each including an outer conductive sleeve surrounding a central signal conductor, and wherein the step of electrically connecting includes connecting the sleeves to the respective ground contacts.

11. The method of claim 10 wherein the step of positioning includes providing a carrier supporting the plurality of conductive column elements.

12. The method of claim 11 wherein the carrier is soluble, and including the step of dissolving the carrier after electrically connecting the column elements

13. The method of claim 11 wherein the carrier includes a plurality of solder elements, and
wherein the method includes directly connecting opposed pairs of secondary contacts on the first and second board faces by way of the solder elements.

14. The method of claim 10 including directly connecting with solder a contact on the first board with a contact on the second board.

15. The method of claim 10 including forming a column element by inserting a central conductor into a dielectric sleeve, and inserting the dielectric sleeve into a shield.

16. The method of claim 15 including bending the central conductor to a right angle.
